## Europäisches Patentamt
## European Patent Office
## Office européen des brevets

(11) Veröffentlichungsnummer: **0 008 399**
**B1**

(12)

# EUROPÄISCHE PATENTSCHRIFT

(45) Veröffentlichungstag der Patentschrift:
02.09.81

(21) Anmeldenummer: 79102833.5

(22) Anmeldetag: 06.08.79

(51) Int. Cl.³: **H 01 L 29/72**, H 01 L 29/08,
H 01 L 27/04

(54) Monolithisch Integrierte Halbleiterschaltung mit mindestens einem Lateraltransistor.

(30) Priorität: 17.08.78 DE 2835930

(43) Veröffentlichungstag der Anmeldung:
05.03.80 Patentblatt 80/5

(45) Bekanntmachung des Hinweises auf die Patenterteilung:
02.09.81 Patentblatt 81/35

(84) Benannte Vertragsstaaten:
FR GB IT

(56) Entgegenhaltungen:
FR-A-2 365 213
US-A-3 967 307

(73) Patentinhaber: SIEMENS AKTIENGESELLSCHAFT Berlin
und München, Postfach 22 02 61, D-8000 München 22 (DE)

(72) Erfinder: Johannsen, Rolf, Dipl.-Phys., Anechostrasse 32,
D-8000 München 82 (DE)

## Monolithisch integrierte Halbleiterschaltung mit mindestens einem Lateraltransistor

Die Erfindung betrifft eine monolithisch integrierte Halbleiterschaltung mit mindestens einem Lateraltransistor, dessen den einen Leitfähigkeitstyp aufweisende Basiszone durch einen über eine Gleichspannung in Sperrichtung vorgespannten pn-Übergang gegen ihre den entgegengesetzten Leitfähigkeitstyp aufweisende Umgebung im Halbleiterkristall abgegrenzt ist.

Um in monolithisch integrierten Halbleiterschaltungen eine ausreichende Entkopplung der die Schaltung aufbauenden Halbleiterelemente zu erreichen, ist es üblich, die einzelnen Halbleiterelemente der Schaltung — soweit dies erforderlich ist — in je einer Isolationswanne zu erzeugen. Unter einer Isolationswanne versteht man einen Halbleiterbereich des einen Leitfähigkeitstyps, der in einen Halbleiterbereich des entgegengesetzten Leitungstyps unter Bildung eines sog. isolierenden pn-Überganges eingebettet ist.

Bei der Herstellung solcher Halbleitervorrichtungen geht man von einem insbesondere aus Silicium bestehenden einkristallinen Halbleiterplättchen des einen Leitfähigkeitstyps als Substrat aus, an dessen einer Oberflächenseite eine einkristalline Schicht desselben Halbleitermaterials jedoch vom entgegengesetzten Leitfähigkeitstyp epitaktisch abgeschieden wird. Durch maskierte Diffusion und/oder Implantation wird dann die epitaktische Schicht mit einer Anzahl von den Leitfähigkeitstyp des Substrats aufweisenden streifenförmigen Isolationszonen versehen, welche über ihre ganze Länge Verbindung mit dem Substrat erhalten und mit diesem eine zusammenhängende Zone des einen Leitfähigkeitstyp bilden, in welcher die noch den entgegengesetzten Leitfähigkeitstyp aufweisenden Teile der epitaktischen Schicht als Inseln eingebettet sind, die jeweils als eine Isolationswanne bei der in üblicher Weise fertigzustellenden monolithisch integrierten Halbleiterschaltung vorgesehen sind. Vorwiegend enthält jede Isolationswanne wenigstens ein Halbleiterelement, z. B. einen Transistor. Der Transistor kann z. B. als pnp-Lateraltransistor ausgestaltet sein, wobei der Emitter-Basis-pn-Übergang und der Kollektor-Basis-pn-Übergang nebeneinander angeordnet sind. Die Isolationswanne bzw. der von der Herstellung der Emitterzone und Kollektorzone des Lateraltransistors nicht erfaßte Teil der Isolationswanne bildet die Basiszone des Transistors, die gegenüber dem außerhalb der Isolationswanne liegenden und nicht zum Transistor gehörenden Bereich des Halbleiterkristalls, vor allem dem Substrat, durch einen pn-Übergang abgegrenzt ist, der während des Betriebes der integrierten Schaltung in Sperrichtung gepolt ist.

Nun ist beim Einsatz von lateralen Transistorstrukturen festzustellen, daß sie ihren Emitterstrom $J_E$ stets in einen lateralen Wirkanteil $J_{EL}$ und einen vertikalen Parasitäranteil $J_{EV}$ aufspalten. Der Parasitäranteil $J_{EV}$ verzweigt sich in einen Rekombinationsanteil (Basisstrom) und in einen zweiten Anteil $J_s$, der in das Substrat, also in das Gebiet außerhalb der Isolationswanne, abfließt.

Dieser Substratstrom erzeugt nun auf seinem Wege zum nächsten metallischen Substratanschluß einen Spannungsabfall mit parasitären Auswirkungen, z. B. durch Umschalten von isolierenden pn-Übergängen in die Flußrichtung, durch Bildung von Mehrschichtern usw., und verursacht im Extremfall die Zerstörung der den Lateraltransistor enthaltenden integrierten Schaltung.

Besonders ungünstig werden die Verhältnisse beim Sättigungsbetrieb. Sobald nämlich im Falle der Ausbildung des Lateraltransistors als pnp-Transistor das Kollektorpotential so weit abgefallen ist, daß der Basis-Kollektor-pn-Übergang in Flußrichtung kommt, so beginnt der Kollektor seinerseits in die Basis zu injizieren und wird zum zweiten Emitter, während das Substrat zum Kollektor wird. Es fließen also wieder Substratströme mit den genannten schädlichen Auswirkungen für den Betrieb und den Bestand der integrierten Halbleiterschaltung. Nur ist in diesem Falle die Stromverstärkung des entstandenen parasitären pnp-Transistors wegen der kleinen Basisweite, der großen Emitterrandlänge und des Fehlens einer abschirmenden Zwischenelektrode erheblich.

Es ist Aufgabe der Erfindung, hier eine Möglichkeit zur Abhilfe anzugeben.

Erfindungsgemäß wird deshalb eine Ausbildung der eingangs definierten monolithisch integrierten Halbleiterschaltung derart vorgeschlagen, daß innerhalb der Kollektorzone des Lateraltransistors eine den Leitfähigkeitstyp der Basiszone des Lateraltransistors aufweisende Halbleiterzone erzeugt und von derselben Elektrode wie der Kollektor des Lateraltransistors sperrfrei kontaktiert ist.

Der Lateraltransistor kann vom pnp-Typ, er kann aber auch auch vom npn-Typ sein. Im folgenden wird der pnp-Typ als Beispiel angeführt. Die Ausführungen gelten für den npn-Typ analog.

Die Anwesenheit der in der Kollektorzone des Lateraltransistors eingebetteten und den entgegengesetzten Leitungstyp zu dieser aufweisenden Halbleiterzone stellt einen invers beschriebenen und die invertierte Zonenfolge zu dem Lateraltransistor aufweisenden Vertikaltransistor mit Kollektor-Basis-Kurzschluß dar, dessen Emitter durch die Basis des Lateraltransistors gebildet ist. Hierdurch werden die Randbedingungen für die Elektroneninjektion in den Emitter des Lateraltransistors entsprechend der Stromverstärkung des inversen Vertikaltransistors verbessert. Bei konstantem Emitterstrom des Lateraltransistors ist demgemäß der Löcherstrom in der Basis des Lateraltransistors und demzufolge auch der parasitäre Substratstrom verringert.

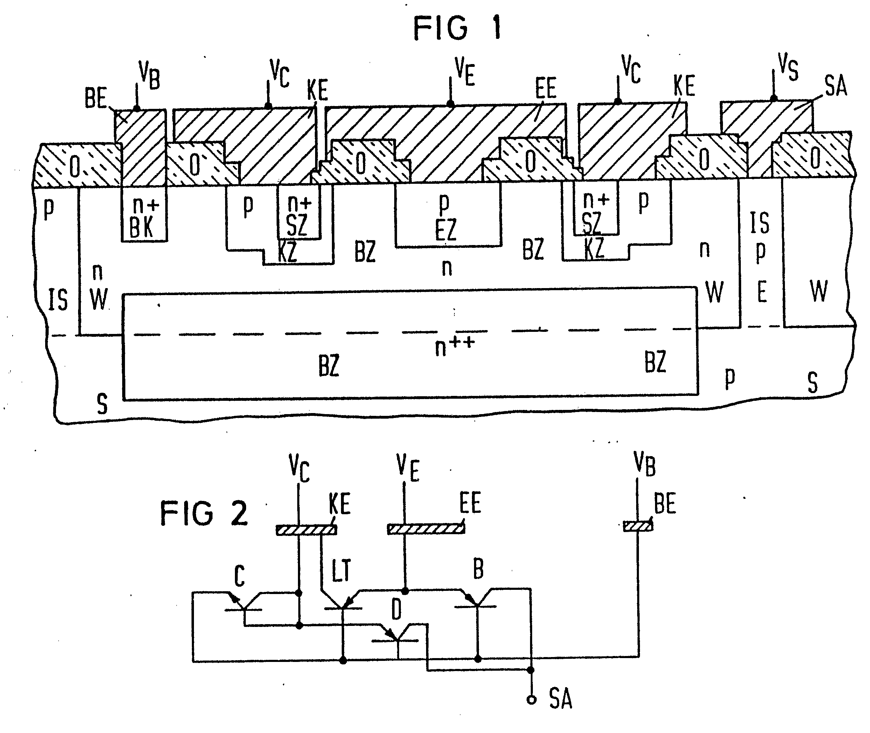

Eine vorteilhafte Ausgestaltung einer Vorrichtung gemäß der Erfindung ist in der Fig. 1 dargestellt, während in Fig. 2 das der Anordnung zugrundeliegende Ersatzschaltbild wiedergegeben ist.

Bei der Herstellung der Anordnung wird, wie üblich, von einem p-leitenden, insbesondere aus monokristallinem Silicium bestehenden Substrat S ausgegangen, an dessen Oberfläche durch maskierte Diffusion und/oder Implantation diskrete n++-dotierte buried-layer-Zonen BZ erzeugt sind, von denen jeweils eine je einer Isolationswanne der herzustellenden integrierten Schaltung zugeordnet ist. Die buried-layer-Zonen erhalten bevorzugt eine rechteckige Gestalt. Die mit den buried-layer-Zonen BZ versehene Oberfläche des Substrats S wird dann mit einer n-leitenden epitaktischen Schicht E aus demselben Halbleitermaterial wie das Substrat S versehen, welche die Grundlage für die Herstellung der für die einzelnen Halbleiterelemente der integrierten Schaltung vorgesehenen n-leitenden Isolationswannen W bildet. Die laterale Abgrenzung der einzelnen Isolationswannen W voneinander wird durch p-leitende streifenförmige Isolationszonen IS geleistet, die durch maskierte Diffusionen und/oder Implantation in der epitaktischen Schicht E erzeugt werden, die auf diese Weise in eine Anzahl von gegeneinander durch jeweils zwei pn-Übergänge isolierte n-leitende Inseln W, also die angestrebten Isolationswannen W, unterteilt wird. Eine dieser Isolationswannen W ist zur Aufnahme des Lateraltransistors LT bestimmt. Diese ist in der Fig. 1 dargestellt. Sie enthält eine buried-layer-Zone BZ.

Der Lateraltransistor LT ist im Beispielsfalle rotationssymmetrisch ausgebildet. Sein Zentrum wird durch die Emitterzone EZ vom p-Typ gebildet, welche äquidistant in kleinem Abstand von der ringförmig ausgestalteten p-leitenden Kollektorzone KZ umgeben ist. In die Kollektorzone KZ ist eine ringförmige n+-dotierte Schutzzone SZ derart eingelassen, daß sie konzentrisch zur Kollektorzone KZ und zur Emitterzone SZ des Lateraltransistors LT verläuft. Sie liegt dabei aus auslegungsoptimierenden Gründen näher dem inneren als dem äußeren Rand der Kollektorzone KZ. Die buried-layer-Zone BZ erstreckt sich mindestens bis zum äußeren Rand der Kollektorzone KZ bzw. der Basisanschlußzone BK des Lateraltransistors LT.

Bei der in Fig. 1 dargestellten Ausführung ist der Lateraltransistor LT als pnp-Transistor ausgebildet, so daß die n-leitende Isolierwanne W als Basis dieses Transistors vorgesehen ist. Der die n-leitende Isolierwanne W einschließlich der buried-layer-Zone BZ umschließende pn-Übergang ist im Betrieb der integrierten Schaltung durch entsprechende Bemessung des Emitterpotentials, des Basispotentials und des Kollektorpotentials in Sperrichtung gepolt.

Entsprechend der Ausbildung des Lateraltransistors LT als pnp-Transistor sind innerhalb der Isolationswanne W, wie bereits oben dargelegt, nebeneinander eine p-leitende Emitterzone EZ und eine p-leitende Kollektorzone KZ durch maskierte Diffusion und/oder Implantation hergestellt. Die in die Kollektorzone KZ eingelassene n+-dotierte Schutzzone SZ wird zweckmäßig gleichzeitig mit der der Kontaktierung der Basiszone BZ des Lateraltransistors LT dienenden Basiskontaktierungszone BK hergestellt, die mit Rücksicht auf die Verwendung von Aluminiumkontakten für die Emitterelektrode EE, die Basiselektrode BE und die Kollektorelektrode KE ebenfalls n+-dotiert ist. Die Kollektorelektrode KE des Lateraltransistors LT erstreckt sich sperrfrei über die Oberfläche der n+-dotierten Schutzzone SZ. Die Halbleiteroberfläche ist im übrigen, wie üblich, durch eine insbesondere aus Siliciumdioxyd bestehende isolierende Schutzschicht O abgedeckt.

Das schaltungstechnische Äquivalent der in Fig. 1 dargestellten Anordnung ist in Fig. 2 angegeben, wobei KE, EE, BE die Kollektor-, die Emitter- und die Basiselektrode der in Fig. 1 dargestellten lateralen Transistoranordnung bedeuten. Daneben ist der bereits in Fig. 1 angedeutete Substratanschluß SA angegeben. Der pnp-Lateraltransistor LT ist gemäß dem Ersatzschaltbild mit einem parasitären pnp-Transistor B verkoppelt, dessen Kollektor jedoch am Substratanschluß SA liegt. Der Parasitärtransistor B kommt deswegen zustande, weil die vom Emitter EZ vertikal injizierten Minoritätsträger als der bereits oben erwähnte Strom $J_{EV}$ auch über den pn-Übergang in das Substrat S gelangen und dort einen Kollektorstrom erzeugen. Im Sättigungsbetrieb des Lateraltransistors LT wird der parasitäre pnp-Transistor D aktiviert, den zu schwächen das Hauptziel dieser Erfindung ist.

Die Schutzzone SZ dient als Kollektor eines inversen npn-Vertikaltransistors C, dessen Emitter durch die Basiszone BZ des Lateraltransistors LT gegeben ist, während der Kollektor des Lateraltransistors die Basis des Transistors C bildet. Entsprechend der oben angegebenen Ausbildung des Kollektorkontakts KE des Lateraltransistors LT ist der Kollektor des npn-Vertikaltransistors C mit der Basis dieses Transistors verbunden.

Zur gleichzeitigen Unterdrückung des parasitären pnp-Transistors B vom Emitter zum Substrat empfiehlt es sich, die Kollektorzone KZ im Bereich der Schutzzone SZ etwas tiefer als sonst in das Innere des Halbleiterkristalls vorzuschieben. Hierzu kann man bei geeigneter Wahl der die Kollektorzone KZ und der die Schutzzone SZ dotierenden Aktivatoren den sogenannten Emitter-Dip-Effekt ausnutzen, der z. B. bei Verwendung von Silicium als Halbleitermaterial sowie von Bor als Dotierung für die p-dotierten und von Phosphor als Dotierung für die n- und n+-Bereiche und bei genügender Annäherung der die Zonen KZ und SZ jeweils umgrenzenden pn-Übergänge erreicht werden kann.

Während des Betriebes der integrierten Schaltung liegt die Kollektorelektrode KE des Lateraltransistors LT an einem Kollektorbetriebspotential $V_C$, die Basis BZ an einem Basispotential $V_B$, der Emitter EZ an einem Emitterpotential $V_E$ und das Substrat S mit seinem Anschluß SA an einem Substratpotential $V_s$. Die den Transistor LT steuernden Signale können dabei entweder dem Emitterpotential oder dem Basispotential überlagert werden. Die Potentiale $V_s$ und $V_B$ müssen so aufeinander abgestimmt sein, daß — wenigstens beim normalen Betrieb der integrierten Schaltung — der die Basiszone BZ nach außen begrenzende pn-Übergang stets in Sperrichtung gepolt ist. Dies bedeutet im in Fig. 1 dargestellten Fall, daß das Substrat S negativ gegen die Basis BZ des Lateraltransistors LT auch dann vorgespannt bleiben soll, wenn die den Transistor LT in Verbindung mit den übrigen Elementen der integrierten Schaltung steuernden Signale über die Basiselektrode BE des Lateraltransistors LT zugeführt werden.

Zusätzlich zu der beschriebenen Ausgestaltung des Lateraltransistors LT mit einer in deren Kollektor eingelassenen Schutzzone SZ können noch die heute allgemein üblichen Maßnahmen zur Schwächung eines Substratstromes Anwendung finden. Diese sind z. B. a) ein möglichst voller metallischer Ringanschluß SA am Substrat S um den den Lateraltransistor LT aufnehmenden Bereich W herum, b) Abschirmelektroden in Form von ringförmigen p-, p+- und n+-dotierten Zonen und c) Vergrößerung des Abstandes zwischen dem Kollektor KZ und dem die Basiszone BZ umgrenzenden pn-Übergang.

Diese Maßnahmen weisen jedoch spezifische Nachteile auf, wie z. B. hohen Platzbedarf, Gefahr der Entstehung von Mehrschichtern sowie eine Zunahme von Oberflächenproblemen, die bei Anwendung dieser Erfindung vermieden werden.

## Patentansprüche

1. Monolithisch integrierte Halbleiterschaltung mit mindestens einem Lateraltransistor, dessen den einen Leitfähigkeitstyp aufweisende Basiszone durch einen über eine Gleichspannung in Sperrichtung vorgespannten pn-Übergang gegen ihre den entgegengesetzten Leitfähigkeitstyp aufweisende Umgebung im Halbleiterkristall abgegrenzt ist, dadurch gekennzeichnet, daß innerhalb der Kollektorzone (KZ) des Lateraltransistors (LT) eine den Leitfähigkeitstyp der Basiszone (BZ) des Lateraltransistors (LT) aufweisende Halbleiterzone (SZ) erzeugt und von derselben Elektrode (KE) wie der Kollektor (KZ) des Lateraltransistors (LT) sperrfrei kontaktiert ist.

2. Monolithisch integrierte Halbleiterschaltung nach Anspruch 1, dadurch gekennzeichnet, daß die spezifische Leitfähigkeit der in die Kollektorzone (KZ) des Lateraltransistors (LT) eingelassenen Zone (SZ) vom Leitfähigkeitstyp der Basiszone (BZ) des Lateraltransistors (LT) höher als die spezifische Leitfähigkeit der Basiszone (BZ) im Bereich zwischen dem Emitter (EZ) und dem Kollektor (KZ) des Lateraltransistors (LT) eingestellt ist.

3. Monolithisch integrierte Halbleiterschaltung nach Anspruch 2, dadurch gekennzeichnet, daß die spezifische elektrische Leitfähigkeit der in die Kollektorzone (KZ) des Lateraltransistors (LT) eingelassenen Zone (SZ) vom Leitfähigkeitstyp der Basiszone (BZ) des Lateraltransistors (LT) höher als die spezifische Leitfähigkeit in der Kollektorzone (KZ) des Lateraltransistors (LT) eingestellt ist.

4. Monolithisch integrierte Halbleiterschaltung nach den Ansprüchen 1 bis 3, dadurch gekennzeichnet, daß die Kollektorzone (KZ) und die Emitterzone (EZ) des Lateraltransistors (LT) in einem gemeinsamen Dotierungsprozeß hergestellt sind.

5. Monolithisch integrierte Halbleiterschaltung nach den Ansprüchen 1 bis 4, dadurch gekennzeichnet, daß die in die Kollektorzone (KZ) des Lateraltransistors (LT) eingelassene Zone (SZ) vom Leitfähigkeitstyp der Basiszone (BZ) des Lateraltransistors (LT) zusammen mit der den Basisanschluß (BE) herstellenden Kontaktierungszone (BK) in einem gemeinsamen Dotierungsprozeß hergestellt ist.

6. Monolithisch integrierte Halbleiterschaltung nach den Ansprüchen 1 bis 5, dadurch gekennzeichnet, daß der Abstand zwischen der in die Kollektorzone (KZ) des Lateraltransistors (LT) eingelassenen Zone (SZ) und der Basiszone (BZ) des Lateraltransistors (LT) an der dem Emitter (EZ) des Lateraltransistors (LT) gegenüberliegenden Seite kleiner als an den dem die Basiszone (BZ) des Lateraltransistors (LT) nach außen begrenzenden pn-Übergang gegenüberliegenden Seiten eingestellt ist.

7. Monolithisch integrierte Halbleiterschaltung nach den Ansprüchen 1 bis 6, dadurch gekennzeichnet, daß die Anordnung der Emitterzone (EZ), der Kollektorzone (KZ) und der in die Kollektorzone (KZ) eingelassenen Zone (SZ) vom Leitfähigkeitstyp der Basiszone (BZ) rotationssymmetrisch ausgebildet ist.

8. Monolithisch integrierte Halbleiterschaltung nach den Ansprüchen 1 bis 7, dadurch gekennzeichnet, daß die Basiszone (BZ) des Lateraltransistors (LT) an dem sie nach außen begrenzenden pn-Übergang unterhalb des Emitters (EZ), des Kollektors (KZ) und des Basisanschlusses (BK) einen gemeinsamen stärker dotierten Bereich (BZ) aufweist.

9. Monolithisch integrierte Halbleiterschaltung nach den Ansprüchen 1 bis 8, dadurch gekennzeichnet, daß die Elektroden des Lateraltransistors (LT) aus der bei der Herstellung des entsprechenden integrierten Schaltkreises verwendeten Metallisierung, insbesondere aus Aluminium, bestehen.

## Claims

1. A monolithically integrated semiconductor circuit having at least one lateral transistor, the base zone of which is of one conductivity type and is separated from its surroundings of the opposite conductivity type in the semiconductor crystal by a pn-junction which is biased in the reverse direction by a direct voltage, characterised in that within the collector zone (KZ) of the lateral transistor (LT), a semiconductor zone (SZ) is formed which has the conductivity type of the base zone (BZ) of the lateral transistor (LT) and is contacted by the same electrode (KE) as the collector (KZ) of the lateral transistor (LT) in a non-rectifying fashion.

2. A monolithically integrated semiconductor circuit as claimed in Claim 1, characterised in that the specific conductivity of the zone (SZ) which has the conductivity type of the base zone (BZ) of the lateral transistor (LT) and which zone is formed in the collector zone (ZK) of the lateral transistor (LT), is so adjusted as to be higher than the specific conductivity of the base zone (BZ) in the region between the emitter (EZ) and the collector (KZ) of the lateral transistor (LT).

3. A monolithically integrated semiconductor circuit as claimed in Claim 2, characterised in that the specific electrical conductivity of the zone (SZ) having the conductivity type of the base zone (BZ) of the lateral transistor (LT) and which zone is inserted in the collector zone (KZ) of the lateral transistor (LT), is adjusted to be higher than the specific conductivity in the collector zone (KZ) of the lateral transistor (LT).

4. A monolithically integrated semiconductor circuit as claimed in Claims 1 to 3, characterised in that the collector zone (KZ) and the emitter zone (EZ) of the lateral transistor (LT) are produced in a common doping process.

5. A monolithically integrated semiconductor circuit as claimed in Claims 1 to 4, characterised in that the zone (SZ) having the conductivity type of the base zone (BZ) of the lateral transistor (LT) and which is inserted in the collector zone (KZ) of the lateral transistor (LT), is produced, together with the contacting zone (BK), which forms the base terminal (BE), in a common doping process.

6. A monolithically integrated semiconductor circuit as claimed in the Claims 1 to 5, characterised in that the distance between the zone (SZ) which ist inserted in the collector zone (KZ) of the lateral transistor (LT), and the base zone (BZ) of the lateral transistor (LT), at the side lying opposite the emitter (EZ) of the lateral transistor (LT), is adjusted to be smaller than at the sides opposite the pn-junction which delimits the base zone (BZ) of the lateral transistor (LT) from its surroundings.

7. A monolithically integrated semiconductor circuit as claimed in Claims 1 to 6, characterised in that the arrangement of the emitter zone (EZ), the collector zone (KZ) and the zone (SZ) of the conductivity type of the base zone (BZ) and which zone is inserted into the collector zone (KZ), is rotationally symmetrical.

8. A monolithically integrated semiconductor circuit as claimed in Claims 1 to 7, characterised in that the base zone (BZ) of the lateral transistor (LT), at the pn-junction which delimits the base zone from its surroundings beneath the emitter (EZ), the collector (KZ) and the base terminal (BK), has a common more highly doped region (BZ).

9. A monolithically integrated semiconductor circuit as claimed in Claims 1 to 8, characterised in that the electrodes of the lateral transistor (LT) consist of a metallisation, in particular of aluminium, which is used in the production of the corresponding integrated switching circuit.

## Revendications

1. Circuit intégré monolithique à semiconducteurs, comportant au moins un transistor latéral dont la zone de base qui possède un premier type de conductivité est limitée, au moyen d'une jonction pn polarisée en direction inverse, par rapport à son environnement dans le cristal semiconducteur, présentant le type de conductivité opposée, caractérisé par le fait qu'à l'intérieur de la zone de collecteur (KZ) du transistor latéral (LT) est produite une zone semiconductrice (SZ) ayant le type de conductivité de la zone de base (BZ) et contactée, sans blocage, avec la même électrode (KE) que celle du collecteur (KZ) du transistor latéral (LT).

2. Circuit intégré monolithique à semiconducteurs selon la revendication 1, caractérisé par le fait que la conductivité spécifique de la zone (SZ) noyée dans la zone de collecteur (KZ) du transistor latéral (LT) et qui a le type de conductivité de la zone de base (BZ) du transistor latéral (LT) est réglée à une valeur supérieure à la conductivité spécifique de la zone de base (BZ) dans la partie située entre l'émetteur (EZ) et le collecteur (KZ) du transistor latéral.

3. Circuit intégré monolithique à semiconducteurs selon la revendication 2, caractérisé par le fait que la conductivité électrique spécifique de la zone (SZ) noyée dans la zone de collecteur (KZ) du transistor latéral (LT) et possédant le type de conductivité de la zone de base (BZ) du transistor latéral (LT), est réglée à une valeur supérieure à conductivité specifique de la zone de collecteur (KZ) du transistor latéral (LT).

4. Circuit intégré monolithique à semiconducteurs selon l'une des revendications 1 à 3, caractérisé par le fait que la zone de collecteur (KZ) et la zone d'émetteur (EZ) du transistor latéral (LT) sont fabriquées dans un procédé de dopage commun.

5. Circuit intégré monolithique à semiconducteurs selon les revendications 1 à 4, caratérisé par le fait que la zone (SZ) noyée dans la zone de collecteur (KZ) du transistor latéral (LT) et qui est du type de conductivité de la zone de base (BZ) du transistor latéral, sont réalisées avec la zone de contact (BK) qui établit la borne de raccordement de la base (BE), dans un même procédé de dopage commun.

6. Circuit intégré monolithique à semiconducteurs selon les revendications 1 à 5, caractérisé par le fait que la distance entre la zone (SZ) noyée dans la zone de collecteur (KZ) du transistor latéral (LT) et la zone de base (BZ) du transistor latéral (LT) est, sur le côté qui est situé en face de l'émetteur (EZ) du transistor latéral (LT), réglée à une valeur inférieure au niveau des côtés qui se situent en face de la jonction pn qui limite vers l'extérieur la zone de base (BZ) du transistor latéral (LT).

7. Circuit intégré monolithique à semiconducteurs selon les revendications 1 à 6, caractérisé par le fait que la disposition de la zone d'émetteur (EZ), de la zone de collecteur (KZ) et de la zone (SZ) noyée dans la zone de collecteur (KZ) et qui est du type de conductivité de la zone de base (BZ), sont réalisées de façon à présenter une symétrie de rotation.

8. Circuit intégré monolithique à semiconducteurs selon les revendications 1 à 7, caractérisé par le fait que la zone de base (BZ) du transistor latéral présente, à la jonction pn qui la limite vers l'ectérieur, en dessous de l'émetteur (EZ), du collecteur (KZ) et de la borne de raccordement de base (BK) une zone commune (BZ) plus fortement dopée.

9. Circuit intégré monolithique à semiconducteurs selon les revendications 1 à 8, caractérisé par le fait que les électrodes du transistor latéral (LT) sont constituées par trois métallisations, plus particulièrement en aluminium, utilisées lors de la fabrication du circuit de commutation intégré correspondant.

# FIG 1

# FIG 2

0 008 399